# EUROPEAN PATENT SPECIFICATION

(11) **EP 3 122 433 B1**
(45) Date of publication and mention of the grant of the patent: **09.01.2019**
(21) Application number: 15707036.8
(22) Date of filing: 22.01.2015
(51) Int. Cl.: C06B 29/22, B01D 9/00, C06B 21/00

(54) **A DISCONTINUOUS CRYSTALLIZATION UNIT FOR THE PRODUCTION OF BALL-SHAPED CRYSTALS**
EINHEIT ZUR DISKONTINUIERLICHEN KRISTALLISIERUNG ZUR HERSTELLUNG VON KUGELFÖRMIGEN KRISTALLEN
UNITÉ DE CRISTALLISATION DISCONTINUE POUR LA PRODUCTION DE CRISTAUX EN FORME DE BILLE

(30) Priority: 28.03.2014 CZ 20140207
(43) Date of publication of application: 01.02.2017
(73) Proprietor: ERUCA TECHNOLOGIES S.R.O., 735 95 Bohumin (CZ)
(72) Inventor: SOUCEK, Martin, 747 06 Opava (CZ); MYSIK, Jan, 708 00 Ostrava-Poruba (CZ); KUPKA, Jan, 724 00 Ostrava-Proskovice (CZ)
(74) Representative: Krmencik, Vaclav
(86) International application number: PCT/CZ2015/000007
(87) International publication number: WO 2015/144096

(56) References cited:
- US-A- 2 288 667
- US-B1- 6 305 178

## Description

### Field of the invention

The invention deals with a discontinuous crystallization unit for the production of small to medium-sized ball-shaped crystals, preferably crystals of ammonium perchlorate (APC).

### Background art

In the prior art several methods for the production of ball-shaped crystals have been described. It is known, both from the theory and practice, that small crystals exhibit higher solubility than larger crystals and that a rectangular crystal surface dissolves more easily that a ball-shaped surface. Crystallization that is conducted in such a way that the temperature periodically fluctuates around the saturated solution temperature is based on this phenomenon. Thus, crystal nuclei, small crystals and rectangular crystal surfaces dissolve more easily and on the other hand, large crystals manifest preferential growth. This way, a rough-grained product is produced.

An example of this method for the production of ball-shaped crystals is e.g. the CS patent 105232 (Nývlt, J., published on April 15, 1962), which describes a crystallization process to obtain a rough-grained product without admixed small crystals. This method is based on the crystal suspension in the mother liquor being exposed to a periodical change of one of the quantities (temperature, pressure, solvent volume) around the equilibrium curve of the saturated solution.

The CS patent 112280 (Nývlt, J., Horáček S., published April 15, 1964) deals with a crystallization process for the production of round crystals. The patented crystallization method is based on the general principle that temperature fluctuation around the saturated solution temperature causes rounding of crystals. This is achieved by circulation of suspension of crystals in a solution between two parts of a device, one of which is above the saturation temperature and the other one below the saturation temperature.

On the basis of the above mentioned process a crystallizer was patented in the Czechoslovak patent 112306 (Nývlt, J.,et al., published on April 15, 1964). It is designed as one device of a generally circular cross-section with a conical bottom part. The crystallizer is divided into two spaces with a partition between which suspension of the crystallized compound circulates. The circulation is ensured by the activity of agitators and static tube plates with an annular shape that are part of both the spaces. The tube plates fulfill the function of heat exchangers at the same time. An optional part is a double exchanger. A suitable connection of the heat exchangers is used to achieve such a situation that the temperatures in both the crystallizer spaces are different so that the temperature of the circulating mixture periodically fluctuates.

The US patent 3,599,701 (Mollerstedt et al., granted on Aug. 17, 1971) deals with a production process of round crystals with a narrow distribution of the particle size. The process consists of two main processes. The first one is dissolution and the other one is crystallization while the suspension (crystals and mother liquor) circulates between them. The dissolution is achieved by inlet of such a quantity of water to the suspension to dissolve a part of the crystals only (primarily the smallest and most rectangular ones). Crystallization is done by air bubbling, which removes a part of water from the suspension. The bubbling together with vigorous agitation of the whole suspension maintains even growth of ball-shaped crystals which is also supported by mutual mechanical interaction of the crystals. A part of the suspension from the crystallizer is removed for separation of the product (crystals). The production is continuous.

Another production method of ball-shaped crystals is based on "beating" of crystals that are formed during the crystallization process with a high-speed agitator. This method produces very small particles, which is associated with a number of problems during further processing of the product (poor filtration capability, product sintering, dust formation). During the crystallization process by beating with a high speed agitator crystal edges are preferably beaten off. However, when this method is used, very small particles (fragments) are additionally formed, which are undesirable.

Ball-shaped crystals of ammonium perchlorate are described in the US patent 3,383,180 (Kralik et al., granted on May 14, 1968) while it deals with a production process of large crystals of ammonium perchlorate-APC (200 to 1000 micrometres) with a low content of inclusions suitable for propellant production. In a dissolution vessel hot (approx. 80°C), nearly saturated solution of APC is prepared. It is prepared by dissolution of crude APC in waste mother liquor and APC suspension in the mother liquor that is supplied from the crystallizer. The resulting solution is fed into the crystallizer (circulation circuit between the crystallizer and the dissolution vessel). The crystallizer contains hot suspension of APC crystals in the mother liquor. By the action of reduced pressure water evaporates and crystals grow. The design of the crystallizer with inserted intermediate partitions and a low-speed agitator installed in a tube ensures axial streaming of the suspension. The bottom part of the crystallizer with the shape of a narrow pipe ("leg"), which the second circulation circuit is connected to at the bottom, has the function of a crystal separator (large crystals fall down, smaller ones are carried upwards). The third circulation circuit of the crystallizer leads through a device with the function of a mill (e.g. a colloidal mill or gear pump) where crystals are ground to a smaller size (up to hundredfold radius reduction); this way particles are produced that will act as new nuclei as well as particles that participate in controlling the saturation of the mother liquor through their dissolution. From the bottom part of the crystallizer the product is removed to the separator where APC crystals are separated from the mother liquor, which returns to the beginning of the process. This process is continuous.

Another US patent of the same author 3,498,759 (Kralik et al., granted on March 3, 1970) deals with a production process of round crystals of ammonium perchlorate-APC (approx. 200 micrometers). The process has two main parts between which suspension of APC crystals in the mother liquor circulates. The first one of them is the "dissolution zone". It is an agitated vessel where heat inlet and an "unsaturated" solution (charge) cause crystal dissolution. The other one is the crystallizer where water evaporates and crystals subsequently grow due to a reduced pressure. The crystallizer consists of a funnel-shaped top part (here, suspension is supplied from the dissolution zone and evaporation occurs) and the bottom part (this is where crystals grow and suspension is routed back to the dissolution zone). From the bottom part of the crystallizer the product is removed to the separator where APC crystals are separated from the mother liquor, which returns to the beginning of the process. This process is continuous.

The US patent 3,222,231 (Markels et al., granted on December 7, 1965) uses a process of high-frequency acoustic vibrations for the production of round APC crystals. The crystallization occurs due to slow cooling of an agitated hot saturated solution of ammonium perchlorate-APC. Simultaneously acting high-frequency acoustic vibrations make sure that the formed APC crystals have a ball-shaped character. Depending on the conditions (especially the crystallization rate) crystals with the size from approx. 5 to approx. 350 micrometers can be obtained.

The above mentioned prior art methods make it obvious that there is a need to produce crystals that would have a small to medium size, having at the same time a ball-like to round shape, using a technology based on a special crystallization device that would make use of the advantages of the above mentioned methods.

It would be preferable to use this device for the production of medium-sized ball-shaped to round crystals of ammonium perchlorate-APC obtained especially from recycling of solid rocket propellant.

Therefore, for this purpose, recycling of APC from propellant should be based on a completely new design and structure of the crystallization unit.

### Summary of the invention

The above mentioned requirements resulting from the prior art are met by
providing a method for the production of ball-shaped crystals of ammonium perchlorate within a discontinuous crystallization unit in accordance with this invention, which is partly based on the above mentioned findings to produce small to medium-sized ball-shaped crystals as these sizes are the most demanded ones in the market.

The crystallization device consists of a specially designed metallic crystallizer fitted with a high-speed agitator that ensures mechanical treatment - mechanical impacting, i.e. "beating" of crystals. Circulation pumps are then used to direct the resulting small particles through a pipe heat exchanger that ensures dissolution of nuclei, small crystals, produced fragments and/or crystal edges and then returned to the crystallizer space, which gives them their round shape.

The object of the invention is a method for the production of ball-shaped crystals of ammonium perchlorate within a discontinuous crystallization unit comprising
- a crystallizer (1) that consists of a metallic cylindrical vessel with its inner surface of a material, having a hardness of at least 120 HB,preferably at least 20014B, wherein the cylindrical vessel has an oval or circular cross-section with a conical or vaulted bottom (12), fitted along its length with a double jacket (4) for cooling of the solution and/or suspension of the solution and crystals and a high-speed agitator (8) of a material, having a hardness of at least 120 HB, preferably at least 200 HB, wherein the high-speed agitator (8) has a drive (9) enabling speed control and thus the rate of the impact of the mechanical action of the agitator on roundness of crystals inside the vessel together with the inner surface of the vessel containing at least 2 baffles (5) of a material, having a hardness of at least 120 HB, preferably at least 200 HB,
- a circulation circuit (11); and
- an interconnection (13) pipeline which is connected to the bottom (12) of the crystallizer (1) and to at least one branch of a circulation circuit (11);
wherein the vessel comprises at least 1 orifice (10) at the top which is fitted with at least 1 independent branch of a circulation circuit (11), said circulation circuit being connected to said orifice (10) from the outside by means of at least 1 circulation pump (2) and through at least 1 heat exchanger (3) for the inlet of a heated solution and/or heated suspension of the solution and crystals for ensuring, together with the cooling double jacket (4) controlled periodic changes of temperatures of the crystal suspension around the cooling curve.

For the discharge of crystal suspension from the crystallizer for further processing the interconnection circuit contains, preferably before the connection line to the circulation circuit branch, a branching element, which may be e.g. a T-piece, with a subsequent branch containing stop valves, which may be a valve, cock, flap valve or slide valve, preferably automatic.

With the use of the above mentioned crystallization unit round crystals have been prepared as e.g. crystals of ammonium perchlorate, which forms crystals with sharp edges under common crystallization conditions.

In accordance with the invention the entire crystallization unit works in a discontinuous regime.

With the use of this device in accordance with the invention and a suitable parameter setting ball-shaped products of a small to medium crystal size from approx. 100 to approx. 300 micrometers, preferably approx. 200 micrometers are obtained, which are the most demanded ones in the market. Crystals produced in this device also exhibit a preferable very narrow particle size distribution.

These crystals are preferably ball-shaped crystals of ammonium perchlorate (APC).

The crystallization device consists of a specially designed discontinuous crystallization unit that comprises a metallic crystallizer fitted with a high-speed agitator with the speed control possibility, which ensures "beating" of the crystals and thus the rate of the mechanical impact of the agitator on roundness of crystals inside the vessel in the mixture of the saturated solution and crystals while the beating is implemented by hitting against the agitator blades as well as hitting against the crystallizer walls of a hard material, but also by the crystals hitting each other.

To improve the efficiency of the rate of mechanical impact on the crystals, i.e. crystal "beating" the crystallizer contains at least 2 baffles inside made of a material with the same hardness as the high-speed agitator and the inner surface of the crystallizer walls.

If the number of these baffles is higher, it is just another design version falling within the scope of this invention.

As the hard material stainless steel, enameled metal or glass can be preferably used while in accordance with the invention it is also necessary for the Brinell hardness of these materials to achieve at least 120 HB, preferably at least 200 HB.

The crystallizer is cooled from the outside nearly all along the length of its surface as a duplicator vessel.

The crystal mixture is circulated, with the use of at least one circulation pump (ensuring crystal beating as well), through at least one heat exchanger, preferably a tubular heat exchanger, which supplies heat on the other hand.

As the circulation pump a centrifugal pump with an open impeller of a hard material as mentioned above can be preferably used.

So the mixture of crystals in the suspension is periodically exposed to temperature oscillation (to ensure preferential growth of bigger and round crystals). The value around which the temperature oscillates decreases during crystallization (thus, crystallization is guided/caused by a temperature reduction of solubility).

The crystallization unit in accordance with the invention is able to provide significant inventive elements of the production technology of round crystals, as:
- preventing the occurrence of undesired fine particles;
- excellent control of the crystallization parameters and thus easy setting of the mean size and distribution range of the particle size;
- excellent reproducibility of crystallization;
- efficient implementation of the mechanical treatment principle-crystal "beating", which is implemented in several ways at the same time (agitator, pump, crystallizer walls and baffles).

In particular, the "beating" intensity can be effected by the hardness of selected materials, number of agitator blades, impeller type of the circulation pump and the number of circulation circuits. The "beating" intensity can be controlled by changes of the agitator speed and/or rotation speed of the pump impeller(s).

The crystallization unit in accordance with the invention is actually provably able to produce round crystals while combining two rounding principles (mechanical treatment-beating and dissolution), allowing preparation of medium-sized, high-quality crystals.

As the crystallization unit in accordance with the invention features the possibility to control the cooling rate and heating rate (temperature difference at the exchanger inlet and outlet), the process is easily and precisely controllable.

Thanks to this crystallization unit all the crystals regardless of their size pass through all the cycles of the "rounding process".

The crystallization unit in accordance with this invention allows crystals to pass through any number of "rounding (dissolution) cycles" in accordance with the regime settings (cooling rate and circulation volume flow) on the order of hundreds to thousands.

Another advantage of the crystallization unit in accordance with the invention is that the unit consists of available, serially produced "conventional" devices and that the entire crystallizer is also of a simple design, i.e. the purchasing costs of the whole unit are not high.

The crystallization unit is discontinuous, of the charge type, which makes it suitable for small-scale production, too.

Another advantage provided by this invention is that the disturbed crystallization process by means of cooling is at the same time a purifying process for crystals unlike evaporation, which results in a high quality (purity) of crystals.

Thus, the crystallization unit in accordance with the invention produces required crystals of sufficient purity, proper size and shape.

### Brief description of Drawings

Fig. 1 - is a schematic drawing of the crystallization unit in accordance with the invention with one circulation circuit.
Fig. 2 - is a schematic drawing of the crystallization unit in accordance with the invention with two circulation circuits.
Fig. 3 - shows round ammonium perchlorate crystals produced by the crystallization unit in accordance with the invention

### Examples

### Example 1

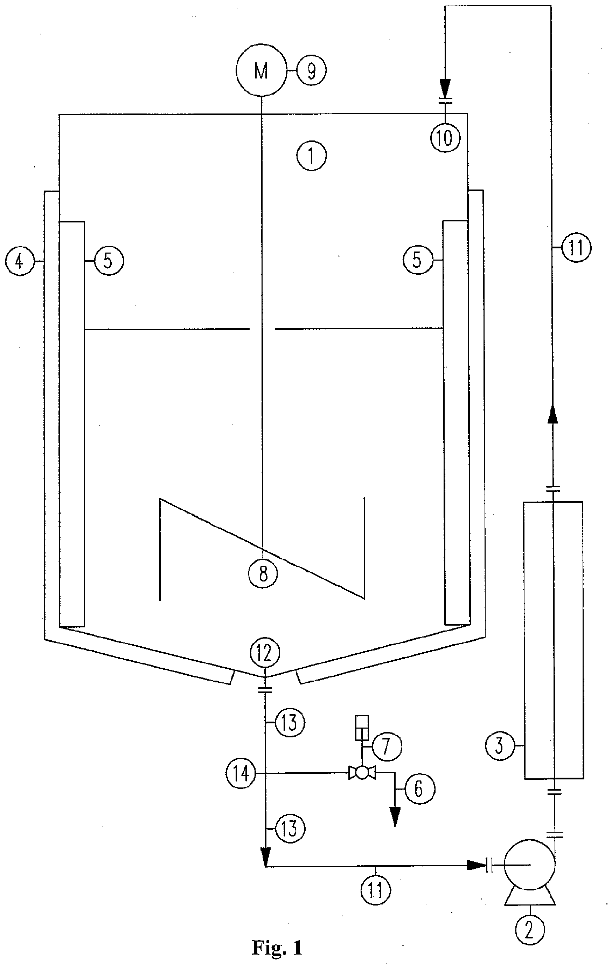

For the production of ball-shaped crystals of ammonium perchlorate a discontinuous crystallization unit has been used that comprised a crystallizer (1) that consisted of a metallic cylindrical vessel of an enameled metal with its inner surface of polished stainless steel, with an oval or circular cross-section with a conical or vaulted bottom (12), fitted along most of its length with a double jacket (4) for cooling of the solution and/or suspension of the solution and crystals and a high-speed agitator (8) of stainless steel with a drive (9) enabling speed control and thus the rate of the impact of the mechanical action of the agitator on roundness of crystals inside the vessel together with the inner surface of the vessel containing 2 baffles (5) of polished stainless steel while the vessel was fitted with 1 orifice (10) at the top that 1 independent circuit of the circulation pipeline (11) was connected to from the outside for the inlet of a heated solution and/or heated suspension of the solution and crystals by means of a circulation centrifugal pump (2) with an open impeller and through a tubular heat exchanger (3) and together with the double jacket (4) ensuring controlled periodic changes of temperatures of the crystal suspension around the cooling curve while an interconnection pipeline (13) was connected to the bottom (12) of the crystallizer (1) vessel that was connected to one circuit of the circulation pipeline (11) as shown in Fig. 1.

The raw material was rough-grained ammonium perchlorate (APC). It was produced during discontinuous crystallization in a plastic crystallizer fitted with cooling diffusers. APC crystals were separated from the mother liquor (ML) on a process filter and dried with process pressurized air. The moisture content of the crystals varied in the range of 5-10% by weight. Further, ML is used for the preparation of the APC solution, which is removed by filtration after the crystallization process described below.

700-1200 kg of rough-grained APC was dissolved in a process filter in 3500-4500 kg of ML, which was preferably heated up by steam using a tubular heat exchanger to a temperature of 50-90 °C. This way an APC solution was produced that was saturated at temperatures in the range of 40-60 °C and then was re-pumped to a plastic tank.

Crystallization was conducted in the crystallizer described above as part of the crystallization unit in accordance with the invention one version of which is schematically illustrated in Fig. 1.

The APC solution from the plastic tank was pumped to the crystallizer in the quantity of 900-1200 kg. The solution was heated up as necessary in the tubular heat exchangers so that the resulting temperature in the crystallizer could vary in the range of 35-65°C. After filling of the crystallizer 1 the pump 2 was started that ensured the total flow of 30-100 m³/h of the APC solution and later the APC suspension through the exchanger 3 during the entire crystallization process.

Then, the agitator 8 was put in operation, the speed of its motor 9 being set with a frequency changer to the value of 60-240 rpm. The agitation also continued throughout the crystallization period.

Then, cooling of the APC solution followed, when in the first stage the solution was cooled to the initial crystallization temperature at the rate of 40-80 °C/h. The initial crystallization temperature was in the range of 30-55 °C. From this temperature the cooling rate was reduced to 2-15°C/h and at the same time heating of the solution, later suspension of APC in the exchanger 3 was started to ensure the 0.2-3.5°C difference between the inlet and outlet APC solution temperature. Steam, water or other heat-carrying media can be used for the heating.

The crystallization process was completed when the temperature achieved 10-25°C. At this temperature heating of the solution by means of the exchanger 3 was turned off and the circulation pumps 2 and the agitator 8 were switched off.

The suspension was then pumped with a suitable pump via the interconnection pipeline 13, the T-piece 14 and automatic stop valves 7, which is a closing valve, and the branching pipe 6 for further processing in the process filter. There, ML is separated from APC crystals. Then, crystals are dried by the process pressure filter to the value of 90-98 % by weight (related to the total weight with residual water).

APC crystals whose particle size distribution in accordance with sieve analysis is within the ranges presented in table 1 were prepared in the above mentioned method.
Table 1 - Sieve analysis of obtained APC crystals

**Table 1**

| Fraction | 0-100 µm | 100-150 µm | 150-180 µm | 180-300 µm | > 300 µm |
|---|---|---|---|---|---|
| Weight % | 3-10 | 4-19 | 12-35 | 40-75 | 0-6 |

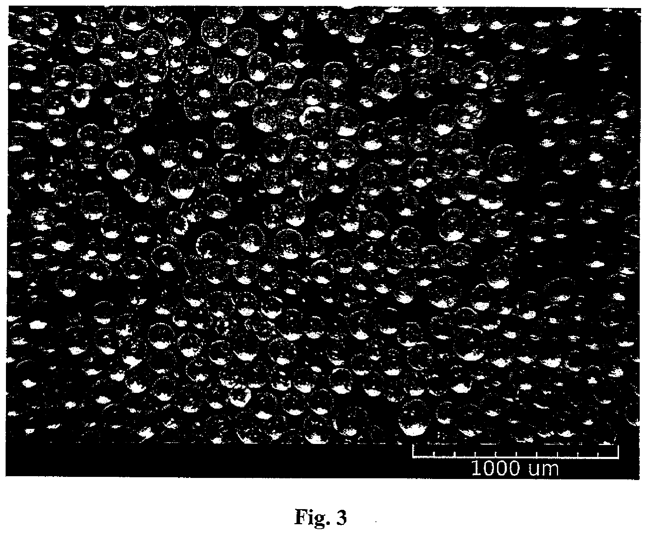

The size and shape of APC crystals are shown in Fig. 3.

### Example 2

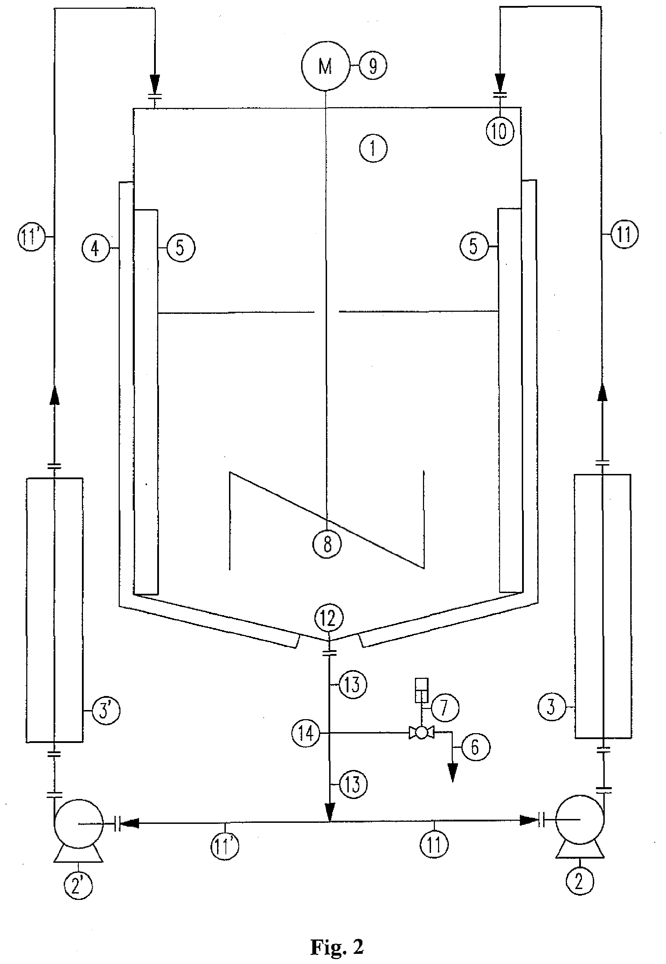

The same discontinuous crystallization unit was used as in Example 1, but it contained 2 circulation circuits 11, 11' for the inlet of the heated solution or heated suspension of solution and crystals with the use of circulation pumps 2, 2' and through heat exchangers 3, 3', as shown in Fig. 2.

This arrangement of the unit made it possible to increase the number of crystallization cycles at the same cooling rate and/or reduce the flow rate in the circulation circuit branch(es).
The general APC crystal production process was the same as in Example 1.

The obtained crystals had a rounder shape; otherwise they exhibited the same purity and particle distribution as compared to Example 1.

## Claims

1. A method for the production of ball-shaped crystals of ammonium perchlorate within a discontinuous crystallization unit comprising
- a crystallizer (1) that consists of a metallic cylindrical vessel with its inner surface of a material, having a hardness of at least 120 HB, preferably at least 200 HB, wherein the cylindrical vessel has an oval or circular cross-section with a conical or vaulted bottom (12), fitted along its length with a double jacket (4) for cooling of the solution and/or suspension of the solution and crystals and a high-speed agitator (8) of a material, having a hardness of at least 120 HB, preferably at least 200 HB, wherein the high-speed agitator (8) has a drive (9) enabling speed control and thus the rate of the impact of the mechanical action of the agitator on roundness of crystals inside the vessel together with the inner surface of the vessel containing at least 2 baffles (5) of a material, having a hardness of at least 120 HB, preferably at least 200 HB,
- a circulation circuit (11); and
- an interconnection (13) pipeline which is connected to the bottom (12) of the crystallizer (1) and to at least one branch of a circulation circuit (11);
wherein the vessel comprises at least 1 orifice (10) at the top which is fitted with at least 1 independent branch of a circulation circuit (11), said circulation circuit being connected to said orifice (10) from the outside by means of at least 1 circulation pump (2) and through at least 1 heat exchanger (3) for the inlet of a heated solution and/or heated suspension of the solution and crystals for ensuring, together with the cooling double jacket (4) controlled periodic changes of temperatures of the crystal suspension around the cooling curve.

2. A method in accordance with claim 1, **characterized in that** the interconnection pipeline (13) before the connection to the circulation circuit branch (11) contains a branching element (14) with a branching pipe (6) with stop valve (7), preferably automatic for discharge crystals for further processing.

3. A method in accordance with claim 2, **characterized in that** the branching element (14) is a T-piece and that the stop valve (7) is a valve, cock, flap valve or slide valve.

4. A method in accordance with claim 1, **characterized in that** the material is stainless steel, enameled metal or glass.

5. A method in accordance with claim 1, **characterized in that** the exchanger(s) is(are) a tubular heat exchanger(s).

6. A method in accordance with claim 1, **characterized in that** the circulation pump(s) is(are) a centrifugal pump(s) with an open impeller of the material.

7. A method in accordance with claim 1, **characterized in that** the ball-shaped crystals are the crystals of a medium size from approx. 100 micrometers to approx. 300 micrometers, preferably approx. 200 micrometers.

## Patentansprüche

1. Verfahren zur Herstellung kugelförmiger Kristalle aus Ammoniumperchlorat in einer Einheit zur diskontinuierlichen Kristallisation, umfassend
- einen Kristallisator (1), der aus einem metallischen zylindrischen Behälter besteht, dessen innere Oberfläche aus einem Material mit einer Härte von wenigstens 120 HB, vorzugsweise wenigstens 200 HB, besteht, wobei der zylindrische Behälter einen ovalen oder kreisförmigen Querschnitt mit einem konischen oder gewölbten Boden (12) aufweist und entlang seiner Länge mit einem Doppelmantel (4) zum Kühlen der Lösung und/oder Suspension der Lösung und der Kristalle ausgerüstet ist, und einem Hochgeschwindigkeitsrührer (8) aus einem Material mit einer Härte von wenigstens 120 HB, vorzugsweise wenigstens 200 HB, wobei der Hochgeschwindigkeitsrührer (8) einen Antrieb (9) aufweist, welcher die Steuerung der Geschwindigkeit und somit der Geschwindigkeit des Einflusses der mechanischen Einwirkung des Rührers auf die Rundheit der Kristalle innerhalb des Behälters zusammen mit der inneren Oberfläche des Behälters, welcher mindestens 2 Stromstörer (5) aus einem Material mit einer Härte von wenigstens 120 HB, vorzugsweise wenigstens 200 HB, enthält,
- einen Zirkulationskreislauf (11) und
- eine Verbindungsrohrleitung (13), die mit dem Boden (12) des Kristallisators (1) und mit mindestens einem Zweig eines Zirkulationskreislaufs (11) verbunden ist,
wobei der Behälter mindestens 1 Öffnung (10) an der Oberseite aufweist, welche an mindestens 1 unabhängigen Zweig des Zirkulationskreislaufs (11) angeschlossen ist, wobei der Zirkulationskreislauf von außen mittels wenigstens 1 Zirkulationspumpe (2) und über wenigstens 1 Wärmetauscher (3) mit der Öffnung (10) verbunden ist, für das Einleiten einer erwärmten Lösung und/oder einer erwärmten Suspension der Lösung und der Kristalle, um, zusammen mit dem kühlenden Doppelmantel (4), gesteuerte periodische Temperaturänderungen der Kristallsuspension um die Abkühlkurve zu gewährleisten.

2. Verfahren gemäß Anspruch 1, **dadurch gekennzeichnet, dass** die Verbindungsrohrleitung (13), vor dem Anschluss an den Zirkulationskreislaufzweig (11), ein Abzweigelement (14) mit einem Abzweigrohr (6) mit Absperrorgan (7), vorzugsweise automatisch, enthält, für den Austrag von Kristallen zur Weiterverarbeitung.

3. Verfahren nach Anspruch 2, **dadurch gekennzeichnet, dass** das Abzweigelement (14) ein T-Stück ist und dass das Absperrorgan (7) ein Ventil, Hahn, Klappenventil oder Schieber ist.

4. Verfahren nach Anspruch 1, **dadurch gekennzeichnet, dass** das Material rostfreier Stahl, emailliertes Metall oder Glas ist.

5. Verfahren nach Anspruch 1, **dadurch gekennzeichnet, dass** der/die Wärmetauscher (ein) Röhrenwärmetauscher ist/sind.

6. Verfahren nach Anspruch 1, **dadurch gekennzeichnet, dass** die Zirkulationspumpe(n) (eine) Kreiselpumpe(n) mit einem offenen Flügelrad aus dem Material ist/sind.

7. Verfahren nach Anspruch 1, **dadurch gekennzeichnet, dass** die kugelförmigen Kristalle Kristalle mittlerer Größe von ungefähr 100 Mikrometer bis ungefähr 300 Mikrometer, vorzugsweise ungefähr 200 Mikrometer sind.

## Revendications

1. Un procédé de production de cristaux de perchlorate d'ammonium en forme de billes dans une unité de cristallisation en discontinu, comprenant
un cristallisoir (1) qui consiste en un récipient cylindrique métallique
où la surface interne est constituée d'un matériau ayant une dureté d'au moins 120 HB, de préférence d'au moins 200 HB,
où le récipient cylindrique a une section transversale ovale ou circulaire et un fond conique ou voûté (12) et est muni sur sa longueur d'une double enveloppe (4) pour le refroidissement de la solution et/ou de la suspension formée de la solution et des cristaux, et comporte un agitateur à grande vitesse (8) formé d'un matériau ayant une dureté d'au moins 120 HB, de préférence d'au moins 200 HB,
où l'agitateur à grande vitesse (8) est doté d'un entraînement (9) permettant le contrôle de la vitesse et donc le taux d'impact de l'action mécanique de l'agitateur sur la rotondité des cristaux à l'intérieur du récipient en même temps que la surface intérieure du récipient contenant au moins deux déflecteurs (5) formé d'un matériau ayant une dureté d'au moins 120 HB, de préférence d'au moins 200 HB,
un circuit de circulation (11), et
une conduite d'interconnexion (13) connectée au fond (12) du cristallisoir (1) et à au moins une branche d'un circuit de circulation (11)
où le récipient comprend au moins un orifice (10) sur sa partie supérieure qui est pourvu d'au moins une branche indépendante d'un circuit de circulation (11),
ce circuit de circulation étant raccordé au dit orifice (10) depuis l'extérieur au moyen d'au moins une pompe de circulation (2) et par au moins un échangeur de chaleur (3) pour l'entrée d'une solution chauffée et/ou d'une suspension chauffée de la solution et des cristaux pour assurer avec la double enceinte de refroidissement (4) des changements périodiques contrôlés des températures de la suspension cristalline autour de la courbe de refroidissement.

2. Un procédé selon la revendication 1, **caractérisée en ce que** la conduite d'interconnexion (13) avant le raccordement à la branche de circuit de circulation (11) contient un élément de dérivation (14) avec un tuyau de dérivation (6) munie d'une vanne d'arrêt (7), de préférence automatique pour la décharge des cristaux pour un traitement ultérieur.

3. Un procédé selon la revendication 2, **caractérisé en ce que** l'élément de dérivation (14) est une pièce en T et **en ce que** la vanne d'arrêt (7) est une vanne, un robinet, un clapet ou une vanne à tiroir.

4. Un procédé selon la revendication 1, **caractérisé en ce que** le matériau est de l'acier inoxydable, du métal émaillé ou du verre.

5. Un procédé selon la revendication 1, **caractérisé en ce que** le ou les échangeurs sont un ou des échangeurs de chaleur tubulaires.

6. Un procédé selon la revendication 1, **caractérisé en ce que** la ou les pompes de circulation sont une ou des pompes centrifuges avec un impulseur ouvert du matériau.

7. Un procédé selon la revendication 1, **caractérisé en ce que** les cristaux en forme de bille sont des cristaux d'une taille moyenne comprise entre environ 100 micromètres et environ 300 micromètres, de préférence approximativement 200 micromètres.
